# EUROPÄISCHE PATENTSCHRIFT

(11) **EP 1 883 140 B1**
(45) Veröffentlichungstag und Bekanntmachung des Hinweises auf die Patenterteilung: **27.02.2013**
(21) Anmeldenummer: 07013821.9
(22) Anmeldetag: 13.07.2007
(51) Int. Cl.: H01S 5/343, H01S 5/30, H01L 33/04, H01L 33/32, H01S 5/32, H01L 33/06, H01L 33/02

(54) **LD oder LED mit Übergitter-Mantelschicht und Dotierungsgradienten**
LD or LED with superlattice clad layer and graded doping
LD ou DEL avec une couche de revêtment superréseau et dopage gradué

(30) Priorität: 27.07.2006 DE 102006034821; 29.09.2006 DE 102006046227
(43) Veröffentlichungstag der Anmeldung: 30.01.2008
(73) Patentinhaber: OSRAM Opto Semiconductors GmbH, 93055 Regensburg (DE)
(72) Erfinder: Eichler, Christoph, Dr., 93105 Tegernheim (DE); Lell, Alfred, 93142 Maxhütte-haidhof (DE)
(74) Vertreter: Epping - Hermann - Fischer

(56) Entgegenhaltungen:
- WO-A-2006/068376
- US-A1- 2002 190 259
- US-A1- 2003 042 479
- US-A1- 2004 051 107
- US-A1- 2005 142 682

## Beschreibung

Diese Patentanmeldung beansprucht die Priorität der deutschen Patentanmeldungen 10 2006 034 821.4 und 10 2006 046 227.0.

Die Erfindung betrifft eine Halbleiter-Schichtstruktur, die ein Übergitter aus alternierend gestapelten Schichten von III-V Verbindungshalbleitern einer ersten und mindestens einer zweiten Zusammensetzung aufweist. Die Erfindung betrifft weiterhin ein optoelektronisches Bauelement, das eine derartige Halbleiter-Schichtstruktur aufweist.

Verglichen mit einer Schicht gleicher Dicke aus nur einem Material einer Zusammensetzung haben Übergitter mit alternierend gestapelten Schichten verschiedener Zusammensetzung unterschiedliche elektrische, optische und epitaktische Eigenschaften. Insbesondere kann bei geeigneter Zusammensetzung und Dotierung ein Übergitter aus alternierend gestapelten p-dotierten Gallium-Nitrid- (GaN) und p-dotierten Aluminium-Gallium-Nitrid- (AlGaN) Schichten eine höhere Leitfähigkeit aufweisen als eine p-dotierte reine GaN- oder AlGaN-Schicht der gleichen Dicke. Aufgrund dieser Eigenschaften finden Übergitter vielfach Verwendung in elektronischen und optoelektronischen Bauteilen.

Beispielsweise ist in der Druckschrift US 2004/0051107 A1 eine Übergitterstruktur bestehend aus Schichten aus Al_{X}Ga_{1-X}N/Al_{y}Ga_{1-y}N beschrieben. Die Schichten enthalten Dotierstoffe in vorgegebenen Konzentrationen, wobei die Konzentrationen der Dotierstoffe in mindestens zwei Schichten einer gleichen Zusammensetzung im Übergitter unterschiedlich sind.

Aufgabe der Erfindung ist es, eine Halbleiter-Schichtstruktur mit Übergitter der eingangs genannten Art mit verbesserten elektrischen und optischen Eigenschaften zu schaffen. Es ist eine weitere Aufgabe der Erfindung, ein optoelektronisches Bauelement mit einer solchen Halbleiter-Schichtstruktur anzugeben.

Diese Aufgabe wird gemäß Patentanspruch 1 durch ein optoelektronisches Bauelement der eingangs genannten Art gelöst, wobei die Schichten des Übergitters Dotierstoffe in vorgegebenen Konzentrationen enthalten, die Konzentrationen der Dotierstoffe in zumindest zwei Schichten einer gleichen Zusammensetzung im Übergitter unterschiedlich sind, die Konzentration der Dotierstoffe innerhalb zumindest einer Schicht des Übergitters gradiert ist, das Übergitter Schichten aufweist, die mit unterschiedlichen Dotierstoffen dotiert sind, die Dotierstoffe Mg und Si sind, oder das Übergitter Schichten aufweist, die mit Mg in unterschiedlichen Konzentrationen dotiert sind, die Schichten erster Zusammensetzung einen in Richtung der aktiven Schicht abfallenden Verlauf der Dotierstoffkonzentration aufweisen und wobei die Schichten zweiter Zusammensetzung einen hierzu umgekehrten Verlauf der Dotierstoffkonzentration aufweisen.

Auf diese Weise können die elektrischen und optischen Eigenschaften des Übergitters bestmöglich an gegebene Erfordernisse angepasst werden. Häufig sind die gegebenen Erfordernisse an das Übergittern nicht über seine gesamte Dicke gleich, beispielsweise weil physikalische Größen, wie eine elektrische oder optische Feldstärke, die Einfluss auf die Erfordernisse haben, ebenfalls über die Dicke des Übergitters nicht konstant sind. Mit einem über dem Übergitter nicht konstanten Dotiergrad, mit einer gradierten Konzentration des Dotierstoffs innerhalb zumindest einer Schicht und mit unterschiedlichen Dotierstoffen in den Schichten des Übergitters oder mit zumindest einer Schicht, die undotiert ist, kann dieser Tatsache Rechnung getragen werden.

Grundsätzlich wird als Übergitter eine Struktur bezeichnet, die eine Periodizität aufweist, deren Periodenlänge größer ist als die Gitterkonstanten eingesetzter Materialien. Im Rahmen der Anmeldung wird als Übergitter eine Folge alternierend gestapelter Schichten bezeichnet, bei der sich in einer Richtung senkrecht zu den Grenzflächen zwischen den Schichten, also z.B. in Aufwachsrichtung der Schichten, eine Schichtabfolge, umfassend mindestens zwei Schichten unterschiedlichen Typs, wiederholt. Alternierend ist dabei so zu verstehen, dass sich zwei oder mehr Schichten abwechseln. Innerhalb der sich wiederholenden Schichtabfolge kann dabei ein Typ durch mehr als eine Schicht vertreten sein. Beispiele für derartige Übergitter sind durch die folgenden Schichtenfolgen gegeben: "ab|ab|ab|...", "abc|abc|abc| ...", "abcb|abcb|..." und "ababababc|ababababc|...", wobei a, b und c jeweils Schichten eines Typs angeben und die sich wiederholende Schichtenabfolge durch das Trennzeichen "|" verdeutlicht ist.

Im Rahmen der Anmeldung ist die Zusammensetzung einer Schicht durch in der Schicht enthaltene Elemente sowie ihre nominelle (d.h. im Rahmen der Genauigkeit der Kompositionsüberwachung während oder nach dem Wachstumsprozess) Stöchiometrie definiert, wobei Dotierstoffe und Verunreinigungen nicht mitberücksichtigt werden. Die Stöchiometrie ist durch den Gehalt (Anteil) der einzelnen Elemente in der Schicht gegeben. Für die Anzahl der Elemente einer Schicht besteht im Rahmen der Anmeldung keine Begrenzung. Die Schichten des Übergitters können z.B. elementar sein, d.h. nur aus einem Element bestehen, oder auch binär, ternär, quaternär usw. sein.

In einer bevorzugten Ausgestaltung weist das Übergitter alternierend gestapelte Schichten von III-V Verbindungshalbleitern einer ersten Zusammensetzung und mindestens einer zweiten Zusammensetzung auf, wobei die Schichten Dotierstoffe in vorgegebenen Konzentrationen enthalten, die Konzentrationen der Dotierstoffe in mindestens zwei Schichten einer gleichen Zusammensetzung im Übergitter unterschiedlich sind, die Konzentration der Dotierstoffe innerhalb zumindest einer Schicht des Übergitters gradiert ist, das Übergitter Schichten aufweist, die mit unterschiedlichen Dotierstoffen dotiert sind und wobei zumindest eine Schicht undotiert ist.

Gemäß einer weiteren vorteilhaften Ausgestaltung der Halbleiter-Schichtstruktur ist den einzelnen Schichten des Übergitters eine vertikale Position innerhalb der Halbleiter-Schichtstruktur zugeordnet und die Konzentration der Dotierstoffe einer Schicht ist in vorgegebener Weise abhängig von ihrer vertikalen Position innerhalb der Halbleiter-Schichtstruktur. Auf diese Weise kann das Übergitter und seine Eigenschaften bestmöglich an sich ändernde physikalische Größen innerhalb der Halbleiter-Schichtstruktur angepasst werden.

Gemäß weiterer vorteilhafter Ausgestaltungen ist die Abhängigkeit der Konzentration der Dotierstoffe von der vertikalen Position entweder für alle Schichten durch eine gemeinsame Funktion vorgegeben oder sie ist für Schichten der ersten Zusammensetzung durch eine erste Funktion und für Schichten der mindestens einen zweiten Zusammensetzung durch mindestens eine zweite Funktion vorgegeben. Besonders bevorzugt ist dabei die erste und/oder die mindestens eine zweite und/oder die gemeinsame Funktion eine Stufenfunktion oder eine monoton steigende/fallende Funktion oder eine lineare Funktion oder eine Polynomfunktion oder eine Wurzelfunktion oder eine exponentielle Funktion oder eine logarithmische Funktion oder eine periodische Funktion oder eine Superposition der genannten Funktionen oder enthält Anteile einer dieser Funktionen.

Beim Betrieb wird in einem optoelektronischen Bauelement ein Strahlungsfeld aufgebaut mit einer üblicherweise innerhalb des Bauelements stark inhomogenen Feldstärkenamplitude. Eine Halbleiter-Schichtstruktur mit einem Übergitter, bei dem zumindest zwei Schichten gleicher Zusammensetzung

Dotierstoffe in unterschiedlicher Konzentration enthalten, kann in seinen elektrischen und optischen Eigenschaften bestmöglich an die herrschende inhomogene Feldstärkenamplitude des optischen Strahlungsfeldes angepasst werden.

Das optoelektronische Bauelement weist eine optisch aktive Schicht auf, und die Konzentration von Dotierstoffen von Schichten einer oder mehrerer Zusammensetzungen innerhalb des Übergitters der Halbleiter-Schichtstruktur steigt mit wachsendem Abstand von der optisch aktiven Schicht. Da bei einem optoelektronischen Bauelement mit optisch aktiver Schicht die Feldstärkenamplitude des Strahlungsfeldes üblicherweise mit wachsendem Abstand von der optisch aktiven Schicht abfällt und eine hohe Dotierstoffkonzentration typisch mit einer hohen optischen Absorption einhergeht, können auf diese Weise optische Verluste verringert werden.

Gemäß weiterer vorteilhafter Ausgestaltungen ist das optoelektronische Bauelement eine Leuchtdiode oder eine Laserdiode.

Weitere vorteilhafte Ausgestaltungen der Erfindung ergeben sich aus den im folgenden in Verbindung mit den in den Figuren beschriebenen Ausführungsbeispielen.

Es zeigen:
- Figur 1: eine Querschnittszeichnung eines optoelektronischen Bauelements mit einer Halbleiterschicht-Struktur mit Übergitter und die
- Figuren 2-3: schematische Darstellungen von Feldstärkenamplitude und Brechungsindex sowie Dotierstoffkonzentration innerhalb eines Übergitters bei verschiedenen Beispielen (Fig. 2 und Fig. 3a) und Ausführungsbeispielen (Fig. 3b) einer Halbleiter-Schichtstruktur mit Übergitter.

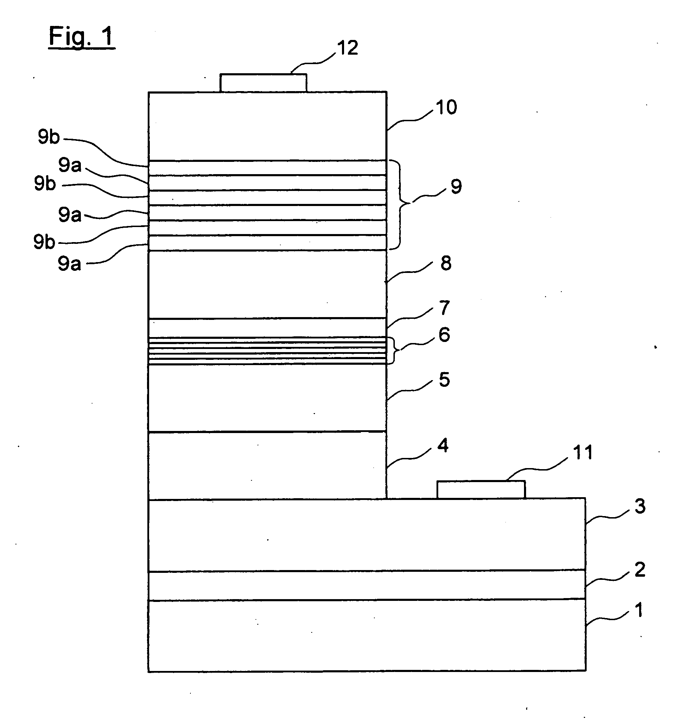

In Figur 1 ist die Schichtenfolge einer Halbleiter-Schichtstruktur eines optoelektronischen Bauelements mit einem Übergitter im Querschnitt schematisch dargestellt. Auf einem Substrat 1 sind eine Anpassungsschicht 2 und folgend eine n-dotierte Kontaktschicht 3 aufgewachsen. Zur einfacheren Darstellung wird der Dotierungstyp von Schichten im Folgenden durch Voranstellen des Buchstabens n oder p angegeben, also z. B. n-Kontaktschicht 3.

Auf der n-Kontaktschicht 3 befindet sich eine n-Mantelschicht 4 und eine n-Wellenleiterschicht 5. Auf diese ist eine aktive Schicht 6 aufgebracht, anschließend eine Barriereschicht 7 sowie eine p-Wellenleiterschicht 8. Es folgt eine p-Mantelschicht, die als Übergitter 9 ausgeführt ist. Das Übergitter 9 weist die alternierend gestapelten Schichten 9a einer ersten Zusammensetzung a und 9b einer zweiten Zusammensetzung b auf. Schichten 9a, 9b gleicher Zusammensetzung a, b werden im Folgenden auch zusammenfassend mithilfe der Bezeichnung Schichtgruppe 9a, 9b referenziert.

Auf das Übergitter 9 ist eine p-Kontaktschicht 10 aufgewachsen. Im rechten Bereich ist die Schichtenfolge durch Abätzen bis auf eine dem Substrat abgewandte Fläche der n-Kontaktschicht 3 abgetragen, beziehungsweise wurde in diesem Bereich durch Maskierung erst gar nicht aufgebaut. Auf der freiliegenden Fläche der n-Kontaktschicht 3 ist ein n-Kontakt 11 aufgebracht. Auf der p-Kontaktschicht 10 befindet sich ein p-Kontakt 12.

Die Figur 1 ist als schematische Zeichnung zu verstehen. Insbesondere sind die gezeigten Schichtdicken nicht maßstabsgetreu.

Das in Figur 1 gezeigte Bauelement stellt eine Doppel-Heterostruktur Laserdiode dar. Im Folgenden ist beispielhaft eine Realisierung im InₓAl_{y}Ga_{1-x-y}N Materialsystem näher beschrieben. In einem solchen Fall kann Saphir als Substrat 1 Verwendung finden und n-dotiertes GaN als n-Kontaktschicht 3 eingesetzt werden. Zur n-Dotierung der GaN-Schicht wird vorzugsweise Silizium (Si) eingesetzt. Als Anpassungsschicht 2 ist typischerweise eine Aluminiumnitrid (A1N) Schicht zwischen dem Saphir-Substrat 1 und der GaN n-Kontaktschicht 3 zur Anpassung der unterschiedlichen Gitterkonstanten dieser Schicht vorgesehen.

Analog kann die p-Kontaktschicht 10 durch eine mit Magnesium (Mg) p-dotierte GaN-Schicht realisiert werden, wobei eine durch die Magnesiumstörstellen induzierte Löcherleitung nach Aufwachsen der Schicht in bekannter Weise aktiviert wird, z.B. durch Elektronenbestrahlung oder thermische Behandlung.

Als n- oder p-Kontakte 11 bzw. 12 können Elektroden, z.B. aus Aluminium oder Nickel, auf die entsprechenden n- oder p-Kontaktschichten 3 bzw. 10 aufgedampft werden. Das zu dem Zweck erforderliche Freilegen der n-Kontaktschicht 3 kann beispielsweise durch einen Trockenätzprozess in Chlorgas oder durch Argon-Ionen-Sputtern erfolgen.

Alternativ kann statt eines nicht leitenden Substrats 1 ein leitendes Substrat, wie z.B. Galliumnitrid (GaN) oder Siliziumkarbid (SiC), eingesetzt werden. In einem solchen Fall kann die n-Kontaktschicht 3 und gegebenenfalls, z.B. beim Einsatz von GaN, die Anpassungsschicht 2 entfallen. Der n-Kontakt 11 kann dann gegenüber dem p-Kontakt 12 auf der der Halbleiter-Schichtstruktur abgewandten Seite des Substrats aufgebracht werden, so dass eine vertikal leitende Halbleiter-Schichtstruktur gebildet wird.

Ohne Einschränkung ist in der Figur 1 ein Ausführungsbeispiel gezeigt, bei dem zunächst n-dotierte Schichten auf das Substrat 1 aufgebracht sind. Eine Anordnung, bei der p-dotierte Schichten näher am Substrat 1 angeordnet sind als die n-dotierten Schichten, ist ebenso möglich. Die beiden Ausführungen können bezüglich der Ladungsträgerinjektion in die Halbleiterschichtstruktur unterschiedliche Eigenschaften aufweisen. Abhängig von den gewünschten Eigenschaften kann sich jede der Ausführungen im Einzelfall als vorteilhaft erweisen.

Die aktive Schicht 6 kann z.B. eine Einfach- oder Mehrfach-Quantenschichtstruktur sein, bei der Indium-Galliumnitrid (InGaN)-Quantenschichten abwechselnd mit AlGaN-Barriereschichten gestapelt sind.

Als Quantenschicht ist im Rahmen der Erfindung eine Schicht zu verstehen, die so dimensioniert oder strukturiert ist, dass eine für die Strahlungserzeugung wesentliche Quantisierung der Ladungsträger-Energieniveaus, zum Beispiel durch Einschluss (confinement), auftritt. Insbesondere beinhaltet die Bezeichnung Quantenschicht keine Angabe oder Einschränkung über die Dimensionalität der Quantisierung. Die Quantenschicht kann einen zweidimensionalen Quantentopf bilden oder strukturelle Elemente mit niedrigerer Dimensionalität wie Quantendrähte oder Quantenpunkte oder Kombinationen dieser Strukturen enthalten.

Darüber hinaus ist auch der Einsatz einer Fotolumineszenzaktiven Schicht, z. B. einer Fremdatom-dotierten InGaN-Schicht als aktive Schicht 6 denkbar.

Die die aktive Schicht 6 umgebenden Schichten (n- und p-Wellenleiterschichten 5 bzw. 8, n-Mantelschicht 4, Übergitter 9 als p-Mantelschicht und Barriereschicht 7) haben eine größere Bandlücke als die aktive Schicht 6. Dieses bewirkt eine Konzentration oder eine Eingrenzung, auch confinement genannt, von Ladungsträgern auf die aktive Schicht 6. Die Anzahl der zu diesem Zweck vorgesehenen Schichten ist nicht auf die in der Figur gezeigte Anzahl von fünf Schichten festgelegt, sondern prinzipiell beliebig.

Weiterhin bilden die die aktive Schicht 6 umgebenden Schichten einen Wellenleiter für die in der aktiven Schicht 6 erzeugte Strahlung. Gute Wellenführungseigenschaften werden erreicht, wenn der Brechungsindex in einer Richtung senkrecht zur aktiven Schicht 6 von dieser aus nach außen abnimmt. Da GaN einen höheren Brechungsindex aufweist als AlGaN, sind die näher an der aktiven Schicht 6 angeordneten n- und p-Wellenleiterschichten 5 bzw. 8 im Ausführungsbeispiel als GaN-Schichten ausgeführt. Die n-Mantelschicht 4 und das Übergitter 9 als p-Mantelschicht sind bevorzugt aluminiumhaltig.

Auf der dem Substrat 1 zugewandten Seite der aktiven Schicht 6 (n-dotierte Seite) kann die Wellenleiterschicht 5 folglich als eine Si-dotierte GaN-Schicht ausgeführt sein und die Mantelschicht 4 entsprechend als eine Si-dotierte AlGaN-Schicht. Auf der dem Substrat 1 abgewandten Seite der aktiven Schicht 6 (p-dotierte Seite) wird analog eine Magnesium (Mg)-dotierte GaN-Schicht als Wellenleiterschicht 8 eingesetzt. Um eine direkte Rekombination von Elektronen, die aus der aktiven Schicht 6 in die Wellenleiterschicht 8 diffundieren, mit den dort befindlichen Löchern zu verhindern, ist zwischen beiden Schichten zusätzlich die Barriereschicht 7 vorgesehen. Diese kann durch eine AlGaN-Schicht realisiert sein, die typischerweise deutlich dünner als die n- und p-Wellenleiterschichten 5 bzw. 8, die n-Mantelschicht 4 oder das Übergitter 9 ausgeführt ist.

Die p-seitige Mantelschicht wird durch das Übergitter 9 realisiert.

Im Ausführungsbeispiel der Figur 1 ist das Übergitter 9 durch abwechselnd angeordnete Schichten 9a der ersten Zusammensetzung a und Schichten 9b der zweiten Zusammensetzung b gebildet. Beispielhaft und wegen einer übersichtlicheren Darstellung sind in der Figur nur je 3 Schichten der zwei verschiedenen Zusammensetzungen a und b gezeigt. In tatsächlichen Umsetzungen der Erfindung weist das Übergitter üblicherweise eine größere Anzahl von Schichten auf, beispielsweise mehrere zehn bis einige hundert Schichten jeder Zusammensetzung. Typische Schichtdicken für eine einzelne Schicht des Übergitters 9 liegen im Bereich von wenigen nm bis hin zu mehreren zehn nm, z.B. zwischen 2 nm und 50 nm und bevorzugt zwischen 3 nm und 10 nm. Schichten gleicher Zusammensetzung weisen nominell (d.h. im Rahmen der Genauigkeit der Schichtdickenkontrolle während oder nach dem Wachstumsprozess) die gleiche Schichtdicke auf. Die Schichten 9a der ersten Zusammensetzung a und die Schichten 9b der zweiten Zusammensetzung b können sich in ihrer Dicke jedoch voneinander unterscheiden (asymmetrisches Übergitter) oder auch gleich sein (symmetrisches Übergitter).

Das Übergitter 9 kann nicht nur, wie gezeigt, aus Schichten mit zwei verschiedenen Zusammensetzungen a, b bestehen, sondern auch aus Schichten mit drei oder mehreren verschiedenen Zusammensetzungen, indem z.B. eine Schichtenfolge "abcdabcdabcd..." oder "abcbabcb..." gebildet wird, wobei c und d Zusammensetzungen sind, die sich voneinander und von der ersten und zweiten Zusammensetzung a und b unterscheiden. Wie bereits ausgeführt, ist im Rahmen der Anmeldung die Zusammensetzung einer Schicht durch in der Schicht enthaltene Elemente sowie ihre nominelle (d.h. innerhalb der Genauigkeit der Kompositionsüberwachung während oder nach dem Wachstumsprozess) Stöchiometrie definiert, wobei Dotierstoffe und Verunreinigungen nicht mitberücksichtigt werden. Im Sinne dieser Definition haben beispielsweise somit Al_{0.1}Ga_{0.9}N Schichten und Al_{0.2}Ga_{0.8}N Schichten unterschiedliche Zusammensetzungen, während eine mit Si n-dotierte GaN-Schicht und eine undotierte GaN-Schicht als Schichten gleicher Zusammensetzung zu betrachten sind. Für die Anzahl der Elemente einer Schicht besteht keine Begrenzung. Die Schichten des Übergitters 9 können z.B. elementar sein, d.h. nur aus einem Element bestehen, oder auch binär, ternär, quaternär usw. sein.

Im GaN-basierten Materialsystem kann das Übergitter 9 als p-Mantelschicht z.B. aus alternierenden Mg-dotierten GaN-Schichten und Mg-dotierten AlGaN-Schichten bestehen. Aufgrund der hohen Aktivierungsenergie der Mg-Dotieratome ist die elektrische Leitfähigkeit von p-dotierten Schichten gering. Zudem hat AlGaN eine größere Bandlücke als GaN und weist aufgrund einer geringeren Dotiereffizienz eine geringere Leitfähigkeit auf. Die Dotiereffizienz gibt an, in welcher Konzentration Dotierstoffe überhaupt vom Material aufgenommen werden und welcher Anteil aufgenommener Dotieratome prinzipiell (d.h. unbeachtlich temperaturbedingter Besetzungseffekte) überhaupt zur Leitfähigkeit beitragen kann. Die Dotiereffizienz ist unter Anderem davon abhängig, welche Gitter- oder Zwischengitterplätzen die Dotieratome einnehmen.

Durch den Einsatz höher und effizienter dotierbarer und somit leitfähigerer GaN-Schichten kann das Übergitter 9 verglichen mit einer p-dotierten reinen AlGaN-Mantelschicht eine erhöhte Leitfähigkeit bei effektiv gleichem Brechungsindex aufweisen. Ein effektiv gleicher Brechungsindex kann durch einen erhöhten Aluminiumgehalt der im Übergitter 9 eingesetzten AlGaN-Schichten verglichen mit der AlGaN-Mantelschicht erreicht werden.

Übergitter, bei dem alle Schichten 9a der ersten Zusammensetzung a beziehungsweise alle Schichten 9b der zweiten Zusammensetzung b die gleiche Dotierung, d.h. gleicher Dotierstoff in gleicher Konzentration, aufweisen, sind z.B. aus der EP 0881666 B1 oder aus der Veröffentlichung von P. Kozodoy et al. in Applied Physics Letters 1999, Vol. 74, Nr. 24, S. 3681 bekannt.

Erfindungsgemäß ist dagegen die Konzentration der Dotierstoffe in zumindest zwei Schichten gleicher Zusammensetzung unterschiedlich. Es gibt also erfindungsgemäß mindestens eine Schicht aus mindesten einer Gruppe von Schichten 9a und/oder 9b, die anders dotiert ist, als die übrigen Schichten der Schichtgruppe.

Des Weiteren ist erfindungsgemäß die Konzentration der Dotierstoffe in zumindest einer Schicht des Übergitters 9 gradiert. Es gibt also erfindungsgemäß mindestens eine Schicht aus mindesten einer Gruppe von Schichten 9a und/oder 9b, die gradiert ist.

Ferner weist erfindungsgemäß das Übergitter 9 Schichten 9a und/oder 9b auf, die mit unterschiedlichen Dotierstoffen dotiert sind. Es gibt also erfindungsgemäß mindestens eine Schicht aus mindesten einer Gruppe von Schichten 9a und/oder 9b, die mit einem anderen Dotierstoff dotiert ist, als die übrigen Schichten.

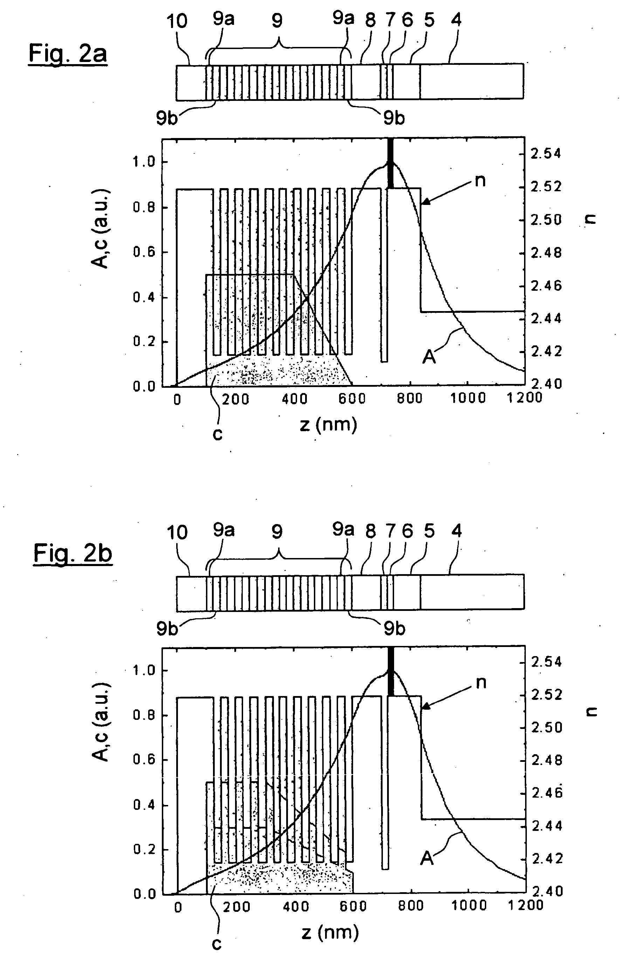

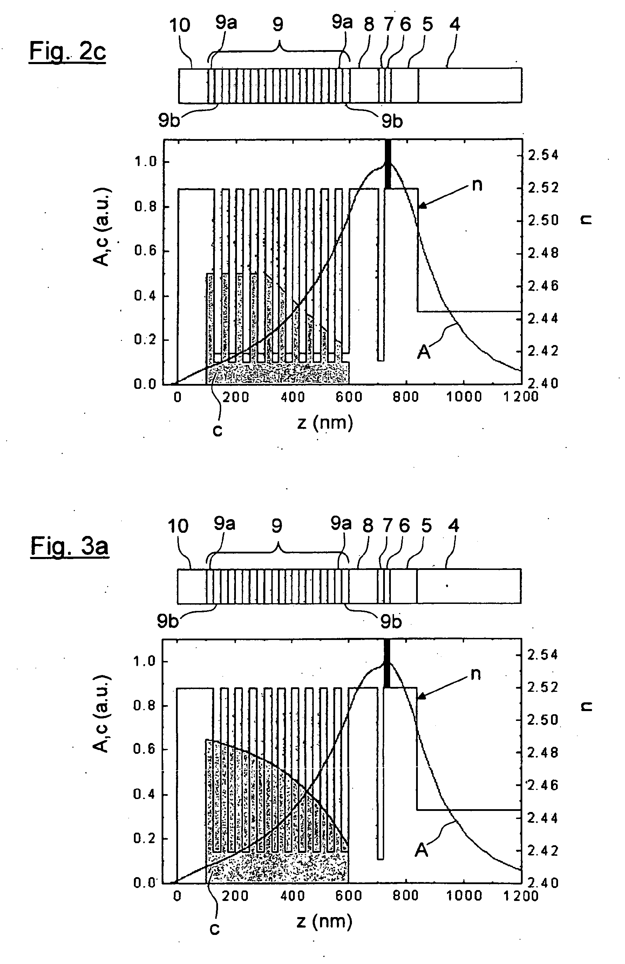

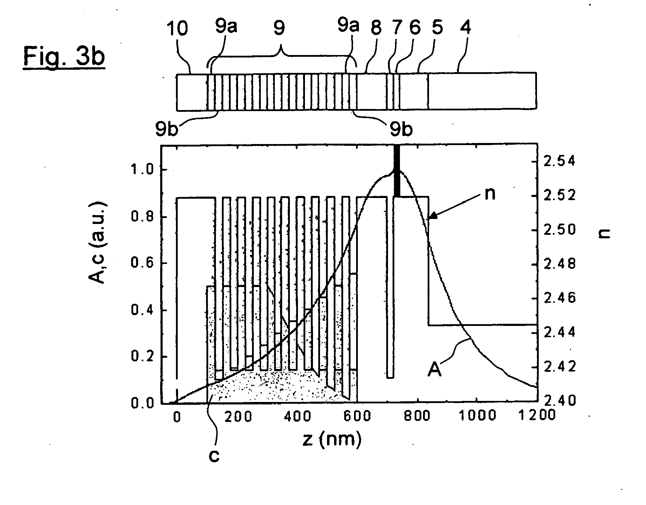

Im Folgenden sind im Zusammenhang mit den Figuren 2 und 3 Halbleiter-Schichtstrukturen beschrieben, bei denen der Dotiergrad von Schichten gleicher Zusammensetzung (Schichtgruppe) innerhalb eines Übergitters variiert. Die Schichtabfolge der im Folgenden gezeigten Ausführungsbeispiele entspricht grundsätzlich dem in Figur 1 gezeigten Beispiel, mit Ausnahme der n-Kontaktschicht 3, der Anpassungsschicht 2 und des Substrats 1, die in den Diagrammen der Figuren 2 und 3 nicht wiedergegeben sind.

In den Figuren 2 und 3 ist jeweils zu verschiedenen Ausführungsbeispielen einer Halbleiter-Schichtstruktur je ein Diagramm gezeigt, in dem ein Brechungsindex n (rechte Ordinate) und eine Feldamplitude A des optischen Strahlungsfeldes (linke Ordinate) abhängig von der vertikalen Position z innerhalb der Halbleiter-Schichtstruktur (Abszisse) angegeben ist. Basierend auf derselben vertikalen Position z ist oberhalb der Diagramme jeweils die zugehörige Schichtabfolge dargestellt, wobei die Schichten mit den gleichen Bezugszeichen versehen sind, wie sie in Figur 1 eingeführt sind. Die vertikale Position z innerhalb der Halbleiter-Schichtstruktur ist von der der aktiven Schicht 6 abgewandten Grenzfläche der p-Kontaktschicht 10 gerechnet entgegen der Aufwachsrichtung in nm angegeben. Selbstverständlich kann die Positionsreferenz beliebig gewählt werden, z.B. könnte eine Seite des Übergitters 9 als Positionsreferenz herangezogen werden.

Da Schichten unterschiedlicher Zusammensetzung unterschiedliche Brechungsindizes aufweisen, kann aus der Darstellung des Brechungsindex n in Abhängigkeit der vertikalen Position z innerhalb der Halbleiter-Schichtstruktur deren Schichtaufbau abgelesen werden. GaN-Schichten weisen einen Brechungsindex n von etwa 2.52 auf. Der Brechungsindex n von AlGaN-Schichten sinkt mit steigendem Al-Gehalt von diesem Wert ab. In den in den Figuren 2-3 gezeigten Ausführungsbeispielen sind die p-Kontaktschicht 10, die p-Wellenleiterschicht 8 und die n-Wellenleiterschicht 5 GaN-Schichten. Die Barriereschicht 7 und die n-Mantelschicht 4 sind AlGaN-Schichten, wobei die Barriereschicht 7 einen hohen und die n-Mantelschicht 4 einen mittleren Al-Gehalt aufweist. Als Dotierstoff zur p-Dotierung kann Mg und als Dotierstoff zur n-Dotierung Si eingesetzt werden.

Das Übergitter 9 wird durch jeweils 10 alternierend gestapelte GaN- / AlGaN-Schichten gebildet. Auch hier ist die Anzahl der Schichten nur beispielhaft und wegen der Übersichtlichkeit nicht zu groß gewählt. Typischerweise weist das Übergitter 9 eine größere Anzahl von Schichten auf, beispielsweise mehrere zehn bis einige hundert Schichten jeder Zusammensetzung. In Analogie zu Figur 1 werden im Folgenden die GaN-Schichten als Schichten einer ersten Zusammensetzung a mit dem Bezugszeichen 9a versehen und die AlGaN-Schichten als Schichten einer zweiten Zusammensetzung b mit dem Bezugszeichen 9b. Das Übergitter weist auf seiner an die p-Kontaktschicht 10 angrenzenden Seite (linke Seite in den Diagrammen) eine GaN-Schicht 9a auf und auf seiner an die p-Wellenleiterschicht 8 angrenzenden Seite (rechte Seite in den Diagrammen) eine AlGaN-Schicht 9b. Das Übergitter 9 fungiert als p-Mantelschicht.

Die Feldamplitude A des optischen Strahlungsfeldes, das beim Betrieb der Halbleiter-Schichtstruktur in der aktiven Schicht 6 erzeugt wird, ist in willkürlichen Einheiten auf der linken Ordinate angegeben. Die Feldamplitude A zeigt in allen Ausführungsbeispielen einen glockenkurvenähnlichen Verlauf mit einem auf den Wert 1 normierten Maximum in der aktiven Schicht 6. Der Abfall der Feldstärke zu beiden Seiten der aktiven Schicht 6 ist durch den Verlauf des Brechungsindex n bestimmt.

Für die Schichten des Übergitters 9 ist darüber hinaus die Dotierstoffkonzentration c, auch Dotiergrad genannt, durch ein der Darstellung überlagertes Säulendiagramm angegeben. Wie die Feldamplitude A ist der Dotiergrad c in willkürlichen Einheiten auf der linken Abszisse angegeben. Falls nicht im Einzelfall anders beschrieben, bezieht sich die dargestellte Dotierstoffkonzentration c auf den zur p-Dotierung eingesetzten Stoff, also z.B. Mg.

Figur 2 zeigt drei Beispiele einer Halbleiter-Schichtstruktur. Diesen Beispielen ist gemeinsam, dass innerhalb einer oder beider Schichtgruppen die Dotierstoffkonzentration c für Schichten in einem Bereich des Übergitters 9 konstant ist und in einem anderen Bereich linear abfällt.

Im Beispiel von Figur 2a ist die Dotierstoffkonzentration c jeweils in den ersten 6 der p-Kontaktschicht 10 zugewandten AlGaN- und GaN-Schichten 9b, 9a (linke Seite im Diagramm) konstant und für beide Schichttypen gleich. In den nächsten vier, der aktiven Schicht 6 zugewandten Schichten fällt die Dotierstoffkonzentration c linear auf Null ab.

Das Beispiel in Figur 2b zeigt einen prinzipiell ähnlichen Verlauf der Dotierung. Hier erstreckt sich der konstante Bereich auf je 4 Schichten, wobei der Dotiergrad für GaN-Schichten 9a höher ist als für AlGaN-Schichten 9b. In den in Richtung der aktiven Schicht folgenden je 6 Schichten fällt die Dotierstoffkonzentration c innerhalb jeder Schichtengruppe linear auf einen jeweils von Null verschiedenen Wert ab.

Im Beispiel von Figur 2c verläuft die Dotierstoffkonzentration c innerhalb des Übergitters 9 für die GaN-Schichten 9a wie in dem Beispiel von Figur 2b, der Dotiergrad der AlGaN-Schichten 9b ist jedoch auf einem niedrigen Niveau konstant.

In den Beispielen von Figur 2 ist durch den sich in Richtung der aktiven Schicht 6 über mehrere Schichten erstreckenden Abfall der Dotiergrad, und damit der Absorptionskoeffizient der Schichten, an den Verlauf der Feldamplitude A angepasst.

Aus dem Verlauf der Feldamplitude A ist ersichtlich, dass die beim Betrieb von der der aktiven Schicht 6 erzeugte Strahlung mit noch fast 80% ihrer maximalen Amplitude in das Übergitter eindringt. Ein Vergleich der Absorptionskoeffizienten für Strahlung einer Wellenlänge von 400 nm zeigt beispielsweise, dass Mg-dotiertes GaN (Dotierstoffkonzentration 4x10¹⁹ cm⁻³) einen 10-fach höheren Absorptionskoeffizienten hat als undotiertes GaN (Quelle: M. Kumerato et al., Phys. stat. sol. 2002, Vol. 192, Nr. 2, S. 329). Insbesondere im Bereich hoher Feldstärken A lassen sich durch die Verwendung von undotierten oder nur sehr gering dotierten Schichten somit Absorptionsverluste im Übergitter 9 verringern. Um einer durch den Einsatz von undotierten oder nur sehr gering dotierten Schichten hervorgerufenen Abnahme der Leitfähigkeit des Übergitters 9 entgegenzuwirken, kann die Dotierstoffkonzentration c in den übrigen Schichten verglichen mit einem Übergitter, das homogen über alle Schichten dotiert ist, geringfügig höher sein. Aufgrund der überlinear abfallenden Feldamplitude A sind mit dem erhöhten Dotiergrad der übrigen Schichten einhergehende geringfügig höhere Absorptionsverluste kleiner als die Verringerung der Absorptionsverluste durch die undotierten Schichten. Das Übergitter 9 hat somit effektiv (in der Summe aller Schichten 9a und 9b) eine geringere Absorption bei gleicher Leitfähigkeit als aus dem Stand der Technik bekannte Übergitter.

Im Rahmen der Anmeldung ist unter einer undotierten Schicht eine nominell, d.h. innerhalb technisch mess- und kontrollierbarer Grenzen, undotierte Schicht zu verstehen ist.

Ein Problem bei Bauelementen mit Mg-dotierten Schichten besteht darin, dass der Dotierstoff Mg beim Betrieb des Bauelements durch Diffusionsprozesse in die aktive Zone migrieren kann, was dort zu hohen optischen Absorptionsverlusten führt. Bei den beschriebenen Übergittern 9 ergibt sich diesbezüglich als ein weiterer Vorteil, dass die undotierten oder gering dotierten, der aktiven Schicht 6 zugewandten Schichten Konzentrationssenken für diffundierendes Mg darstellen und so einer Migration des Mg bis in die aktiven Schicht 6 hinein entgegenwirken.

Alternativ kann in allen gezeigten Ausführungsbeispielen auch vorgesehen sein, mit Si n-dotierte Schichten statt der undotierten Schichten einzusetzen. Der Absorptionskoeffizient von Si-dotierten GaN-Schichten liegt zwischen dem einer undotierten und einer mit Mg dotierten Schicht (bei gleicher Dotierstoffkonzentration c wie im Fall von Si). Eventuell kann sich eine etwas geringere Leitfähigkeit ergeben als beim Einsatz undotierter Schichten, eine Ausbildung von leitungshindernden, in Sperrrichtung betriebenen p-n Übergängen tritt jedoch bei Schichten einer Dicke, wie sie im Übergitters typisch vorgesehen ist, nicht auf.

Auch beim Einsatz von Si-dotierten Schichten innerhalb des Übergitters werden so optische Absorptionsverluste verringert und gleichzeitig eine hohe Leitfähigkeit des Übergitters 9 erreicht. Darüber hinaus wirken Si-dotierten Schichten als Diffusionsbarriere für diffundierendes Mg und wirken so auf ähnliche Weise wie undotierte Schichten einer Migration des Mg bis in die aktiven Schicht 6 hinein entgegen.

Verallgemeinert kann der Verlauf der Dotierstoffkonzentration c, auch Dotierprofil genannt, innerhalb des Übergitters 9 durch eine (Hüllkurven-) Funktion beschrieben werden, die die Dotierstoffkonzentration c einer Schicht abhängig von der Position der Schicht angibt. Dabei kann entweder eine gemeinsame Funktion für alle Schichtengruppen vorgegeben sein, wie z.B. bei den Beispielen der Figuren 2a und 3a (siehe unten), oder es kann für jede Schichtengruppe eine eigene Funktion vorgegeben sein, wie z.B. in den Figuren 2b, 2c und 3b (siehe unten). Die Beispiele der Figur 2 lassen sich durch eine Superposition aus Stufenfunktion und linearer Funktion beschreiben. Prinzipiell ist selbstverständlich aber jeder beliebige, z.B. nichtlineare, Funktionsverlauf möglich.

Beispiele für Halbleiter-Schichtstrukturen mit nichtlinearen Dotierprofilen sind in Figur 3 gezeigt. Im Beispiel von Figur 3a ist der Verlauf der Dotierstoffkonzentration c für beide Schichtgruppen (Schichten 9a, 9b) gleich. Der Verlauf ist in Richtung der aktiven Schicht 6 überlinear monoton fallend und annähernd spiegelbildlich dem Verlauf der Feldamplitude A angepasst, so dass in Bereichen hoher Feldstärke eine geringe optische Absorption herrscht. In Bereichen niedriger Feldstärken ist der Absorptionskoeffizient zwar hoch, es herrscht aber nur eine niedrige absolute optische Absorption. Es kann ein Optimum zwischen geringem Überlapp der optischen Strahlung mit stark absorbierenden Bereichen und dennoch guter elektrischer Leitfähigkeit erreicht werden.

Im Ausführungsbeispiel von Figur 3b ist das Dotierprofil für die GaN- und die AlGaN-Schichten 9a, 9b unterschiedlich. Für die stark absorbierenden GaN-Schichten 9a ist wiederum ein in Richtung der aktiven Schicht 6 abfallender Verlauf der Dotierstoffkonzentration c vorgesehen. Bei den aufgrund ihrer größeren Bandlücke prinzipiell weniger stark absorbierenden AlGaN-Schichten 9b ist der Verlauf zum Ausgleich der elektrischen Leitfähigkeit tendenziell umgekehrt. Dieses Ausführungsbeispiel zeigt einen guten Kompromiss zwischen geringer optischer Absorption und guter elektrischer Leitfähigkeit für den Fall, dass die gesamte Mg-Dotierstoffmenge innerhalb des Übergitters 9 beschränkt sein soll. Ohne diese Einschränkung ist auch denkbar, alle AlGaN-Schichten 9b mit einer konstant hohen Mg-Konzentration zu dotieren.

Innerhalb einer Schicht kann die Dotierstoffkonzentration c im Übergitter 9 gradiert sein. Beispiele, bei denen innerhalb eines nicht konstanten Dotierprofils der Dotiergrad auch innerhalb einer Schicht nicht konstant ist, sind in den Figuren 2, 3a und 3b (hier nur GaN-Schichten 9a) gegeben. In diesem Fall folgt die Dotierstoffkonzentration c innerhalb einer Schicht dem Verlauf der (Hüllkurven-) Funktion. Bei den AlGaN-Schichten 9b in Figur 3b variiert dagegen der Dotiergrad innerhalb der Schichtengruppen, ist aber für jede einzelne Schicht konstant. In einem solchen Fall definiert der Wert der (Hüllkurven-) Funktion an einer festgelegten Position innerhalb jeder Schicht, z.B. jeweils in der Mitte einer Schicht, die Dotierstoffkonzentration c für die gesamte Schicht. Ein gradierter Dotiergrad innerhalb einer Schicht kann den leitfähigkeitserhöhenden Effekt eines Übergitters unterstützen.

Der innerhalb einer Schichtengruppe und auch innerhalb einer Schicht des Übergitters 9 tatsächlich vorliegende Verlauf der Dotierstoffkonzentration c kann, z.B. durch Diffusionsprozesse, von dem im Herstellungsprozess nominell vorgegebenen Konzentrationsverlauf abweichen. In der Praxis kann sich diese Abweichung z.B. in einem Aufweichen oder Ausschmieren von Stufen oder Bereichen mit hohem Konzentrationsgradienten äußern, was sich auf die grundsätzlichen Eigenschaften des erfindungsgemäßen Übergitter 9 jedoch nicht auswirkt und dessen Vorteile gegenüber bekannten, homogen dotierten Übergittern nicht mindert.

## Patentansprüche

1. Optoelektronisches Bauelement, das eine aktive Schicht (6) aufweist, wobei
- die aktive Schicht (6) zwischen Wellenleiterschichten (5, 8) angeordnet ist,
- zwischen der aktiven Schicht (6) und einer der Wellenleiterschichten (8) eine Barriereschicht (7) angeordnet ist,
- jeweils auf der der aktiven Schicht abgewandten Seite der Wellenleiterschichten (5, 8) eine Mantelschicht angeordnet ist,
- zumindest eine Mantelschicht eine Halbleiter-Schichtstruktur umfasst, die ein Übergitter (9) aus alternierend gestapelten Schichten (9a, 9b) von III-V Verbindungshalbleitern einer ersten Zusammensetzung (a) aus GaN und mindestens einer zweiten Zusammensetzung (b) aus AlGaN umfasst, wobei
- die Schichten (9a, 9b) Dotierstoffe in vorgegebenen Konzentrationen enthalten,
- die Konzentrationen der Dotierstoffe in mindestens zwei Schichten einer gleichen Zusammensetzung im Übergitter (9) unterschiedlich sind,
- die Konzentration der Dotierstoffe innerhalb zumindest einer Schicht (9a, 9b) des Übergitters (9) gradiert ist,
- das Übergitter (9) Schichten aufweist, die mit unterschiedlichen Dotierstoffen dotiert sind, wobei die Dotierstoffe Mg und Si sind, oder das Übergitter (9) Schichten aufweist, die mit Mg in unterschiedlichen Konzentrationen dotiert sind,
- die Schichten erster Zusammensetzung (a) aus GaN einen in Richtung der aktiven Schicht abfallenden Verlauf der Dotierstoffkonzentration aufweisen, und
- die Schichten zweiter Zusammensetzung (b) aus AlGaN einen hierzu umgekehrten Verlauf der Dotierstoffkonzentration aufweisen.

2. Optoelektronisches Bauelement nach Anspruch 1, bei der das Übergitter (9) zumindest eine Schicht aufweist, die undotiert ist.

3. Optoelektronisches Bauelement nach einem der vorhergehenden Ansprüche, bei der einzelnen Schichten des Übergitters (9) eine vertikale Position z innerhalb der Halbleiter-Schichtstruktur zugeordnet ist und die Konzentration der Dotierstoffe einer Schicht (9a, 9b) in vorgegebener Weise abhängig von ihrer vertikalen Position z innerhalb der Halbleiter-Schichtstruktur ist.

4. Optoelektronisches Bauelement nach Anspruch 3, bei der die Abhängigkeit der Konzentration der Dotierstoffe von der vertikalen Position z für alle Schichten (9a, 9b) des Übergitters (9) durch eine gemeinsame Funktion vorgegeben ist.

5. Optoelektronisches Bauelement nach Anspruch 3, bei der die Abhängigkeit der Konzentration der Dotierstoffe von der vertikalen Position z für Schichten (9a) der ersten Zusammensetzung (a) durch eine erste Funktion und für Schichten (9b) der mindestens einen zweiten Zusammensetzung (b) durch mindestens eine zweite Funktion vorgegeben ist.

6. Optoelektronisches Bauelement nach einem der Ansprüche 4 oder 5, bei der die erste und/oder die mindestens eine zweite und/oder die gemeinsame Funktion eine Stufenfunktion oder eine monoton steigende/fallende Funktion oder eine lineare Funktion oder eine Polynomfunktion oder eine Wurzelfunktion oder eine exponentielle Funktion oder eine logarithmische Funktion oder eine periodische Funktion oder eine Superposition der genannten Funktionen ist oder Anteile einer dieser Funktionen enthält.

7. Optoelektronisches Bauelement nach einem der vorhergehenden Ansprüche, bei der die Konzentration der Dotierstoffe innerhalb zumindest einer Schicht (9a, 9b) des Übergitters (9) konstant ist.

8. Optoelektronisches Bauelement nach einem der vorhergehenden Ansprüche, das eine Leuchtdiode ist.

9. Optoelektronisches Bauelement nach einem der vorhergehenden Ansprüche 1 bis 7, das eine Laserdiode ist.

## Claims

1. Optoelectronic component comprising an active layer (6), wherein
- the active layer (6) is arranged between waveguide layers (5, 8),
- a barrier layer (7) is arranged between the active layer (6) and one of the waveguide layers (8),
- a cladding layer is arranged in each case on that side of the waveguide layers (5, 8) which faces away from the active layer,
- at least one cladding layer comprises a semiconductor layer structure comprising a superlattice (9) composed of alternately stacked layers (9a, 9b) of III-V compound semiconductors having a first composition (a) composed of GaN and at least one second composition (b) composed of AlGaN, wherein
- the layers (9a, 9b) contain dopants in predefined concentrations,
- the concentrations of the dopants in at least two layers having an identical composition in the superlattice (9) are different,
- the concentration of the dopants within at least one layer (9a, 9b) of the superlattice (9) is graded,
- the superlattice (9) has layers doped with different dopants, wherein the dopants are Mg and Si, or the superlattice (9) has layers doped with Mg in different concentrations,
- the layers having a first composition (a) composed of GaN have a dopant concentration profile that decreases in the direction of the active layer, and
- the layers having a second composition (b) composed of AlGaN have a dopant concentration profile opposite thereto.

2. Optoelectronic component according to Claim 1, wherein the superlattice (9) has at least one layer that is undoped.

3. Optoelectronic component according to either of the preceding claims, wherein individual layers of the superlattice (9) are assigned a vertical position z within the semiconductor layer structure and the concentration of the dopants of a layer (9a, 9b) is dependent on its vertical position z within the semiconductor layer structure in a predefined manner.

4. Optoelectronic component according to Claim 3, wherein the dependence of the concentration of the dopants on the vertical position z is predefined by a common function for all the layers (9a, 9b) of the superlattice (9).

5. Optoelectronic component according to Claim 3, wherein the dependence of the concentration of the dopants on the vertical position z is predefined by a first function for layers (9a) having the first composition (a) and by at least one second function for layers (9b) having the at least one second composition (b).

6. Optoelectronic component according to either of Claims 4 and 5, wherein the first and/or the at least one second and/or the common function are/is a step function or a monotonically rising/falling function or a linear function or a polynomial function or a root function or an exponential function or a logarithmic function or a periodic function or a superposition of the stated functions or contain(s) portions of one of these functions.

7. Optoelectronic component according to any of the preceding claims, wherein the concentration of the dopants within at least one layer (9a, 9b) of the superlattice (9) is constant.

8. Optoelectronic component according to any of the preceding claims, which is a light-emitting diode.

9. Optoelectronic component according to any of the preceding Claims 1 to 7, which is a laser diode.

## Revendications

1. Composant optoélectronique qui présente une couche active (6),
la couche active (6) étant disposée entre des couches (5, 8) de guide d'onde,
une couche de barrière (7) étant disposée entre la couche active (6) et l'une des couches (8) de guide d'onde,
une couche d'enveloppe étant disposée sur chaque côté des couches (5, 8) de guide d'onde non tourné vers la couche active,
au moins une couche d'enveloppe comprend une structure semi-conductrice stratifiée qui comporte un superréseau (9) constituée de couches (9a, 9b) empilées en alternance de semi-conducteur de liaison III-V d'une première composition (a) en GaN et d'au moins une deuxième composition, (b) d'AlGaN,
les couches (9a, 9b) contenant des substances de dopage à des concentrations prédéterminées,
les concentrations des substances de dopage d'au moins deux couches d'une même composition du superréseau (9) étant différentes,
la concentration des substances de dopage à l'intérieur d'au moins une couche (9a, 9b) du superréseau (9) étant graduée,
le superréseau (9) présente des couches dopées de différentes substances de dopage, les substances de dopage étant Mg et Si, ou le superréseau (9) présentant des couches dopées au Mg à différentes concentrations,
les couches d'une première composition (a) en GaN présentent une évolution de la concentration en substances de dopage qui diminue en direction de la couche active et
les couches d'une deuxième composition (b) en AlGaN présentent une évolution inverse de la concentration en substances de dopage.

2. Composant optoélectronique selon la revendication 1, dans lequel le superréseau (9) présente au moins une couche non dopée.

3. Composant optoélectronique selon l'une des revendications précédentes, dans lequel une position verticale z est associée aux différentes couches du superréseau (9) à l'intérieur de la structure semi-conductrice stratifiée, la concentration des substances de dopage d'une couche (9a, 9b) dépendant de manière prédéterminée de sa position verticale z à l'intérieur de la structure semi-conductrice stratifiée.

4. Composant optoélectronique selon la revendication 3, dans lequel la dépendance de la concentration des substances de dopage vis-à-vis de la position verticale z est prédéterminée par une fonction commune pour toutes les couches (9a, 9b) du superréseau (9).

5. Composant optoélectronique selon la revendication 3, dans lequel la dépendance de la concentration des substances de dopage vis-à-vis de la position verticale z est prédéterminée par une première fonction pour les couches (9a) de la première composition (a) et par au moins une deuxième fonction pour les couches (9b) de la ou des deuxièmes compositions (b).

6. Composant optoélectronique selon l'une des revendications 4 ou 5, dans lequel la première fonction, la ou les deuxièmes fonctions et/ou la fonction commune sont une fonction en gradins, une fonction croissant ou décroissant de manière monotone, une fonction linéaire, une fonction polynomiale, une fonction racine carrée, une fonction exponentielle, une fonction logarithmique, une fonction périodique ou une superposition desdites fonctions, ou contient des parties de l'une de ces fonctions.

7. Composant optoélectronique selon l'une des revendications précédentes, dans lequel la concentration des substances de dopage est constante à l'intérieur d'au moins une couche (9a, 9b) du superréseau (9).

8. Composant optoélectronique selon l'une des revendications précédentes, qui est une diode luminescente.

9. Composant optoélectronique selon l'une des revendications 1 à 7 qui précèdent, qui est une diode laser.
